# EUROPÄISCHE PATENTSCHRIFT

(11) **EP 0 619 521 B1**
(45) Veröffentlichungstag und Bekanntmachung des Hinweises auf die Patenterteilung: **29.10.1997**
(21) Anmeldenummer: 94104894.4
(22) Anmeldetag: 28.03.1994
(51) Int. Cl.: G03F 7/031, G03F 7/09

(54) **Photopolymerisierbare Druckschicht für Flexo-Druckplatten**
Photopolymerizable printing layer for flexographic printing plates
Couche d'impression photopolymérisable pour des clichés flexographiques

(30) Priorität: 07.04.1993 DE 4311540
(43) Veröffentlichungstag der Anmeldung: 12.10.1994
(73) Patentinhaber: DU PONT DE NEMOURS (DEUTSCHLAND) GMBH, 61343 Bad Homburg v.d.H. (DE)
(72) Erfinder: Abele, Werner, D-63263 Neu-Isenburg (DE)

(56) Entgegenhaltungen:
- BE-A- 657 526
- DE-A- 1 905 012
- DE-A- 3 603 124
- US-A- 4 036 585
- US-A- 4 234 486
- US-A- 4 716 097
- 'Colour Index, Volume 4', 1971 , THE SOCIETY OF DYERS AND COLOURISTS , BRADFORD, GB

## Beschreibung

Die Erfindung betrifft ein photopolymerisierbares Aufzeichnungsmaterial, enthaltend ein polymeres Bindemittel, ein additionspolymerisierbares Monomer und als Farbstoff ein Reaktionsprodukt aus Phthalocyaninpolysulfonylchlorid-Metallkomplexen und Alkylaminen mit mindestens 11 Kohlenstoffatomen und eine Druckplatte, insbesondere für den Flexodruck, die einen solchen Farbstoff enthält.

Es ist bekannt, für die Herstellung von Druckformen, insbesondere für den Flexodruck, photopolymerisierbare Aufzeichnungsmaterialien zu verwenden, bei denen die Druckoberfläche durch bildmäßiges Belichten einer lichtempfindlichen Schicht und anschließendes Entfernen der unbelichteten Schichtteile erzeugt wird.
Beispiele für solche Aufzeichnungsmaterialien finden sich in den folgen-den Patentschriften: DE-C 22 15 090, US-A 4,266,005; US-A 4,320,188; US-A 4,126,466 und US-A 4,430,417. Solche photopolymerisierbaren Druckplatten setzen sich üblicherweise aus einem Schichtträger, ggf. einer Haft- oder anderen Unterschicht, einer photopolymerisierbaren Schicht, die mindestens ein polymeres Bindemittel, mindestens einadditionspolymerisierbares, ethylenisch ungesättigtes Monomer und einen Photoinitiator enthält, und einer Deckschicht zusammen. Zwischen der photopolymerisierbaren Schicht und der Deckschicht, die vor der Belichtung entfernt wird, befindet sich üblicherweise ein flexibler, reißfester Polymerfilm. Diese Poylmerschicht ermöglicht eine klebfreie Negativauflage bei der Belichtung der Druckplatte.

Eine bevorzugte Methode zur Herstellung solcher mehrschichtigen, photopolymerisierbaren Druckplatten ist ein Verfahren, bei dem in den Spalt eines Kalanders eine vorher extrudierte, photopolymerisierbare Masse eingeführt und zwischen einen Täger und ein Deckelement kalandriert wird, wodurch eine photopolymerisierbare Schicht zwischen ihnen gebildet wird.

Aus der EP-B 00 84 851 ist ein Herstellungsverfahren für eine mehrschichtige, photopolymerisierbare Druckplatte bekannt, die zwischen der flexiblen, reißfesten Polymerschicht und der photopolymerisierbaren Schicht eine elastomere Schicht besitzt, die ein elastomeres Bindemittel, ggf. ein zweites Bindemittel, ggf. einen Farbstoff, ggf. ein oder mehrere Monomere und ggf. einen Photoinitiator enthält.

Solche Druckplatten enthalten üblicherweise einen Farbstoff in einer ihrer Aufzeichnungsschichten, wie z.B. Acid Blue (C.I. 13 390) oder ein Kupfer-Phthalocyanin (C.I. 74 160). Aus der DE-C 1905012 ist es bekannt, u.a. lösliche KupferPhthalocyaninfarbstoffe zu verwenden, so auch das Isohexylamin-Salz der Kupferphthalocyaninfarbstoffe gemäß Color-Index Nr. 74350.

Die gemäß des Standes der Technik verwendeten Farbstoffe haben jedoch den Nachteil, daß sie bei der Druckplattenherstellung nicht hinreichend stabil sind und bei der Entwicklung mit ausgewaschen werden, und daß die Verarbeitungsbreite der Druckplatten zu gering ist.

Der vorliegenden Erfindung lag daher die Aufgabe zugrunde, photopolymerisierbare Aufzeichnungsmaterialien zur Verfügung zu stellen, die zur Herstellung von Druckplatten, insbesondere für den Flexodruck, mit hohem Farbkontrast zwischen druckenden und nicht druckenden Bereichen geeignet sind.

Diese Aufgabe wurde überraschenderweise gelöst durch ein photopolymerisierbares Aufzeichnungsmaterial enthaltend mindestens ein polymeres Bindemittel, mindestens ein additionspolymerisierbares, ethylenisch ungesättigtes Monomer, einen Photoinitiator oder ein Photoinitiatorsystem und einen Farbstoff, wobei als Farbstoff ein Reaktionsprodukt aus Phthalocyaninpolysulfonylchlorid-Metallkomplexen und Alkylaminen mit mindestens 11 Kohlenstoffatomen verwendet wird.

Der besondere Vorteil dieser erfindungsgemäßen Farbstoffe ist, daß sie beim Entwickeln der bildmäßig belichteten Druckplatten nicht aus der Aufzeichnungsschicht ausgewaschen werden, so daß ein hoher Farbkontrast zwischen druckenden und nicht druckenden Bereichen der Druckplatte gewährleistet ist. Desweiteren beeinträchtigen die erfindungsgemäßen Farbstoffe die Verarbeitungsbreite der Druckplatten nicht und können somit in allen gängigen Druckplatten verwendet werden. Als entwicklungsbeständige Farbstoffe werden die Reaktionsprodukte von Phthalocyaninpolysulfonylchlorid-Metallkomplexen und Alkylaminen mit mindestens 11 Kohlenstoffatomen in der Alkylkette verwendet. Insbesondere Kupferphthalocyanin-Komplexe sind geeignet. Als Alkylamine werden vor allem solche mit einem Alkylteil von 11 bis 20 Kohlenstoffatomen verwendet. Erwähnt seien insbesondere iso-Undecylamin, n-Dodecylamin und n-Octadecylamin. Das Umsetzungsprodukt aus Kupferphthalocyaninpolysulfonylchlorid und iso-Undecylamin ist bekannt unter der Color-Index-Nr. 74 400. Die Dodecyl- und Octadecylprodukte werden durch Umsetzung von Kupferphthalocyaninsulfonsäuretetranatriumsalz mit Phosphorpentachlorid zu dem entsprechenden Tetrasulfonylchlorid und anschließende Reaktion mit den gewünschten Aminen hergestellt. Dabei entstehen sowohl Sulfonylamid- als auch Sulfonsäureammoniumsalz-Gruppen, üblicherweise in einem Verhältnis von 2:1 bis 3:1.

Die erfindungsgemäßen Farbstoffe werden der jeweiligen Aufzeichnungsschicht in Mengen von 0,05 bis 5,0 Gew-%, bevorzugt 0,1-1,0 Gew.-% zugesetzt.

Die erfindungsgemäßen Aufzeichnungsschichten enthalten mindestens ein elastomeres Bindemittel. Geeignet sind z.B. Blockcopolymere wie sie in DE-C 2215090; US-A 4,320,188 und US-A 4,162,919 beschrieben werden. Bevorzugt werden Blockcopolymere vom A-B-A-Typ, die einen elastomeren Block, z.B. Polybutadien oder Polyisopren, zwischen zwei thermoplastischen Blöcken, z.B. Polystyrol, besitzen. Besonders bevorzugt werden lineare und radiale Blockcopolymere mit Polytyrol-Endblöcken verwendet, wie z.B. Polystyrol-Polyisopren-Polystyrol, Polystyrol-Polybutadien)₄Si oder (Polystyrol-Polyisopren)₄Si. Das mittlere Molekulargewicht der Blockcopolymere sollte zwischen 80.000 und 300.000 liegen, bevorzugt zwischen 100.000 und 250.000. Der Polystyrolanteil sollte 10 bis 40 Gew.-% betragen, bevorzugt 15 bis 30 Gew.-%. Insbesondere radiale (Polystyrol-Polybutadien)₄Si-Blockcoplymere mit einem Polystyrolgehalt von 15-30 Gew.-% werden bevorzugt.
Aber auch die Verwendung von 2-Blockcopolymeren sowohl solchen mit scharfem als auch solche mit verschmiertem. Übergang zwischen den Polymerblöcken ist möglich.
Die photopolymerisierbare Schicht enthält außerdem mindestens ein additionspolymerisierbares, ethlyenisch ungesättigtes Monomer. Hierbei kann es sich sowohl um Monomere mit einer ethylenisch ungesättigten Gruppe als auch um solche mit mehreren ethylenisch ungesättigten Gruppen handeln. Die Monomere können allein oder auch in Kombination miteinander eingesetzt werden, wie es z.B. in der DE-C 3744243 beschrieben ist. Als Beispiele seien genannt: Octylacrylat, Isodecylacrylat, Isodecylmethacrylat, 2-Hexyloxyethylacrylat, 1,4-Butandioldiacrylat, Butandioldiacrylat, 1,6-Hexandioldiacrylat, 1,6-Hexandiolmethacrylat, Trimethylolpropantriacrylat.

Desweiteren enthält die photopolymerisierbare Schicht einen Photoinitiator oder ein Photoinitiatorsystem, z.B. O-Methylbenzoin, Benzophenon, Benzildimethyl-Ketal oder Ethylanthrachinon/4,4-Bis-(dimethylamino)-benzophenon. Ferner kann die photopolymerisierbare Schicht weitere Zusätze wie z.B. Füllstoffe, Antioxidantien und Plastifizierungsmittel enthalten. Die photopolymerisierbare Schicht enthält allgemein 50-95 Gew.-% Bindemittel, 5-30 Gew-% Monomer und 0.5-5 Gew.-% Initiator.

Als Schichtträger eignen sich Kunststoffolien, wie z.B. Polyesterfolien, die ggf. mit einer Haftschicht und/oder einer Antihaloschicht versehen sein können. Bevorzugt werden Polyethylenterephthalatfolien verwendet.

Druckplatten, die die erfindungsgemäßen Farbstoffe enthalten, können nach allen üblichen Verfahren hergestellt werden. Eine bevorzugte Methode zur Herstellung solcher Druckplatten ist ein Verfahren, bei dem in den Spalt eines Kalanders eine vorher extrudierte, erfindungsgemäße photopolymerisierte Masse eingeführt und zwischen einen Träger und ein Deckelement kalandriert wird, wodurch eine photopolymerisierbare Schicht zwischen ihnen gebildet wird.

Besonders bevorzugt werden erfindungsgemäße Druckplatten nach dem in der EP-B 00 84 851 beschriebenen Verfahren hergestellt. Hierbei wird eine vorher extrudierte photopolymerisierbare Masse in den Spalt eines Kalanders eingeführt und zwischen einen Träger und ein Deckelement, bestehend aus einer Deckfolie und einer elastomeren Schicht, die den erfindungsgemäßen Farbstoff enthält, kalandriert, wodurch eine photopolymerisierbare Schicht gebildet wird.

Die genannte elastomere Schicht enthält neben den erfindungsgemäßen Farbstoffen mindestens ein elastomeres Bindemittel, wobei die für die photopolymerisierbare Schicht eingeführten thermoplastischen Blockcopolymere bevorzugt werden, insbesondere die dort genannten radialen (Polystyrol-Polybutadien)₄Si-Blockcopolymere. Desweiteren kann diese elastomere Schicht auch additionspolymerisierbare ethylenisch ungesättigte Monomere enthalten. Bevorzugt werden die für die photopolymerisierbare Schicht genannten Monomere verwendet. Weitere übliche Hilfsstoffe wie Initiatoren, Füllstoffe, Weichmacher, Antioxidenten, Lösungsmittel, etc. können ebenfalls zugesetzt werden.
Die elastomere Schicht sollte eine Dicke von 0.01 bis 0.5 mm, bevorzugt 0.025 bis 0.12 mm, haben. Die Schicht kann durch Gießen aus Lösungsmitteln wie Toluol, Aceton, Methylchlorid, Methylisobutylketon oder Mischungen dieser Lösungsmittel oder durch Extrusionsbeschichtung direkt auf die Deckfolie, z.B. eine Polyethylenterephthalatfolie, hergestellt werden.

Die so hergestellten photopolymerisierbaren Druckplatten werden üblicherweise nach dem Entfernen der Deckfolie durch eine Photovorlage bildmäßig belichtet. Ggf. erfolgt eine vollflächige Belichtung durch den Schichtträger vor oder nach der bildmäßigen Belichtung. Anschliessend werden die nicht polymerisierten Bereiche der photopolymerisierbaren Schicht und der elastomeren Schicht durch Auswaschen mit einem üblichen Entwicklerlösungsmittel entfernt. Nach dem Trocknen können die so erhaltenen Druckformen zur Herstellung einer klebfreien Druckoberfläche in beliebiger Reihenfolge nachbelichtet und chemisch nachbehandelt werden.

Die folgenden Beispiele sollen die vorliegende Erfindung verdeutlichen. Die angegebenen Prozente beziehen sich, soweit nichts anderes angegeben, auf das Gewicht.

### Beispiel 1

### Herstellung von Säureamiden/Aminsalzen der Kupferphthalocyanin-tetrasulfonsäure

98,4 g (0,1 Mol) Kupferphthalocyanin-tetrasulfonsäuretetranatriumsalz wurden in einer Reibschale mit 104 g (0,5 Mol) Phosphorpentachlorid vermischt und eine Stunde auf 150°C erhitzt.
Das erkaltete Reaktionsgemisch wurde mit Eiswasser ausgewaschen, abfiltriert und an der Luft getrocknet. Hiervon wurden jeweils 10,3 g (0.01 Mol) in Toluol mit der doppeltmolaren Menge folgender Amine umgesetzt;
- n-Decylamin
- n-Dodecylamin
- n-Octadecylamin.

Die toluolische Phase wurde im Scheidetrichter mit Wasser ausgeschüttelt und über Natriumsulfat getrocknet.

### Beispiel 2

Für die Herstellung von elastomeren Schichten wurden 20%ige Lösungen einer Mischung aus

| | |
|---|---|
| Linearem Block-Copolymer aus Polybutadien und Polystyrol (25 % Styrol-Anteil) | 55,57 % |
| Radialem Polystyrol-Polybutdadien-Polystyrol Blockcopolymer (30 % Styrol-Anteil) | 27,78 % |
| Tri-tert.-butylphenol | 2,66 % |
| Benzil-α, α-dimethylketal | 3,99 % |
| Pentaerythrit-triacrylat | 3,99 % |
| Polybutadien mit einem mittleren Molekulargewicht von 1000 | 6,01 % |

verwendet, welche mit 0,5 % der in Beispiel 1 synthetisierten Farbstoffe sowie mit dem iso-Hexylamin-Produkt Zapon Blau 806 (C.I. 74350) und dem iso-Undecylamin-Produkt Zapon Blau 807 (C.I. 74400) eingefärbt worden waren.
Hiermit wurden auf eine polyamidbeschichtete Polyethylenterephthalatfolie ein Trockenauftrag von 350 mg/dm2 aufgebracht und nach dem Trocknen auf DuPont Cyrel® HOF Flexodruckplatten auflamininert.
Nach einer Lagerzeit von 24 Stunden bei 60°C wurden die Plattenmuster vollflächig 12 Min. mit UV belichtet und mit einem Gemisch aus 70 Gew.-% Isoheptylacetat und 30 Gew.-% Isoheptylalkohol ausgewaschen.

### Ergebnisse:

| Farbstoff | Farbe der elastomeren Schicht |
|---|---|
| iso-Hexylamin-Produkt Zapon Blau 806 | farblos |
| n-Decylamin Derivat | farblos |
| iso-Undecylamin-Produkt Zapon Blau 807 | blau |
| n-Dodecylamin-Derivat | blau |
| n-Octadecylamin-Derivat | blau |

Hiernach wurden nur Säureamidderivate der Kupferphtalocyanintetrasulfonsäure mit einer Kettenlänge über 10 nicht ausgewaschen.

## Patentansprüche

1. Photopolymerisierbares Aufzeichnungsmaterial enthaltend mindestens ein polymeres Bindemittel, mindestens ein additionspolymerisierbares, ethylenisch ungesättigtes Monomer, einen Photoinitiator oder ein Photoinitiatorsystem und einen Farbstoff,
dadurch gekennzeichnet, daß
als Farbstoff ein Reaktionsprodukt aus Phthalocyaninpolysulfonylchlorid-Metallkomplexen und Alkylaminen mit mindestens 11 Kohlenstoffatomen verwendet wird.

2. Photopolymerisierbares Aufzeichnungsmaterial nach Anspruch 1,
dadurch gekennzeichnet, daß
Kupferphthalocyanine verwendet werden.

3. Photopolymerisierbares Aufzeichnungsmaterial nach Anspruch 1 oder 2,
dadurch gekennzeichnet, daß
Alkylamine mit 11 bis 20 Kohlenstoffatomen verwendet werden.

4. Photopolymerisierbare Druckplatte im wesentlichen bestehend aus
a) einem Schichtträger
b) mindestens einer photopolymerisierbaren Schicht, enthaltend mindestens ein elastomeres Bindemittel, mindestens ein additionspolymerisierbares, ethylenisch ungesättigtes Monomer und einen Photoinitiator oder ein Photoinitiatorsystem und
c) einer Deckfolie,
dadurch gekennzeichnet, daß
die photopolymerisierbare Schicht einen Farbstoff gemäß einem der Ansprüche 1 bis 3 enthält.

5. Photopolymerisierbare Druckplatte nach Anspruch 4,
dadurch gekennzeichnet, daß
die photopolymerisierbare Schicht 50 bis 95 Gew.-% eines thermoplastisch elastomeren Blockcopolymeren mit einem Polystyrolgehalt von 10-40 Gew.-% enthält.

6. Photopolymerisierbare Druckplatte nach Anspruch 5,
dadurch gekennzeichnet, daß
die photopolymerisierbare Schicht mindestens ein radiales (Polystyrol-Polybutadien)₄Si-Blockcopolymer mit einem Polystyrolgehalt von 15-30 Gew.-% enthält.

7. Photopolymerisierbare Druckplatte im wesentlichen bestehend aus
a) einem Schichtträger
b) einer photopolymerisierbaren Schicht, enthaltend mindestens ein elastomeres Bindemittel, mindestens ein additionspolymerisierbares, ethylenisch ungesättigtes Monomer und einen Photoinitiator oder ein Photoinitiatorsystem
c) einer elastomeren Schicht enthaltend mindestens ein thermoplastisch elastomeres Blockcopolymer und
d) einer Deckfolie,
dadurch gekennzeichnet, daß
die elastomere Schicht einen Farbstoff gemäß einem der Ansprüche 1 bis 3 enthält.

8. Photopolymerisierbare Druckplatte nach Anspruch 7,
dadurchgekennzeichnet, daß
die elastomere Schicht 50-95 Gew.-% eines thermoplastisch elastomeren Blockcopolymeren mit einem Polystyrolgehalt von 10-40 Gew.-% enthält.

9. Photopolymerisierbare Druckplatte nach Anspruch 8,
dadurch gekennzeichnet, daß
die elastomere Schicht mindestens ein radiales (Polystyrol-Polybutadien)₄Si-Blockcopolymer mit einem Polystyrolgehalt von 15-30 Gew.-% enthält.

10. Verfahren zur Herstellung photopolymerisierbarer Druckplatten, bei denen in den Spalt eines Kalanders eine photopolymerisierbare Masse aus mindestens einem elastomeren Bindemittel, mindestens einem additionspolymerisierbaren, ethylenisch ungesättigten Monomer und einem Photoinitiator oder einem Photoinitiatorsystem eingeführt und zwischen einem Träger ein mehrschichtiges Deckelement kalandiert wird und die photopolymerisierbare Schicht zwischen ihnen gebildet wird, wobei das mehrschichtige Deckelement im wesentlichen aus einer elastomeren Schicht, enthaltend mindestens ein thermoplastisch elastomeres Blockcopolymer und einer Deckfolie besteht,
dadurch gekennzeichnet, daß
die elastomere Schicht einen Farbstoff gemäß Anspruch 1 bis 3 enthält.

## Claims

1. Photopolymerizable recording material comprising at least one polymeric binder, at least one addition-polymerizable, ethylenically unsaturated monomer, a photoinitiator or a photoinitiator system, and a dye,
characterized in that,
the dye is a reaction product of phthalocyanine polysulfonyl chloride metal complexes and alkyl amines having at least 11 carbon atoms.

2. Photopolymerizable recording material according to claim 1,
characterized in that,
copper phthalocyanine is used.

3. Photopolymerizable recording material according to claim 1 or 2,
characterized in that,
alkyl amines having 11 to 20 carbon atoms are used.

4. Photopolymerizable printing plate consisting essentially of
a) a support,
b) at least one photopolymerizable layer containing at least one elastomeric binder, at least one addition-polymerizable, ethylenically unsaturated monomer, and a photoinitiator or a photoinitiator system, and
c) a cover sheet
characterized in that,
the photopolymerizabel layer contains a dye according to claims 1 - 3.

5. Photopolymerizable printing plate according to claim 4,
characterized in that,
the photopolymerizable layer contains 50 - 95 percent by weight of a thermoplastic, elastomeric block copolymer with a polystyrene content of 10 to 40 percent by weight.

6. Photopolymerizable printing plate according to claim 5,
characterized in that,
the photopolymerizable layer contains at least one radial (polystyrene-polybutadiene)₄Si block copolymer with a polystyrene content of 15 to 30 percent by weight.

7. Photopolymerizable printing plate consisting essentially of
a) a support,
b) at least one photopolymerizable layer containing at least one elastomeric binder, at least one addition-polymerizable, ethylenically unsaturated monomer, and a photoinitiator or a photoinitiator system, and
c) an elastomeric layer containing at least one thermoplastic, elastomeric block copolymer, and
d) a cover sheet
characterized in that,
the elastomeric layer contains a dye according to claims 1 - 3.

8. Photopolymerizable printing plate according to claim 7,
characterized in that,
the elastomeric layer contains 50 - 95 percent by weight of a thermoplastic, elastomeric block copolymer with a polystyrene content of 10 to 40 percent by weight.

9. Photopolymerizable printing plate according to claim 8,
characterized in that,
the elastomeric layer contains at least one radial (polystyrene-polybutadiene)₄Si block copolymer with a polystyrene content of 15 to 30 percent by weight.

10. Process for the preparation of photopolymerizable printing plates comprising feeding into the nip of a calender a photopolymerizable composition containing at least one elastomeric binder, at least one addition-polymerizable monomer, and a photoinitiator or a photoinitiator system, and calendering the composition between a support and a multilayer cover element to form a photopolymerizable layer, wherein the multilayer cover element consists essentially of an elastomeric layer comprising at least one thermoplastic elastomeric block copolymer, and a cover sheet,
characterized in that,
the elastomeric layer contains a dye according to claims 1 - 3.

## Revendications

1. Matériau d'enregistrement photopolymérisable contenant au moins un liant polymère, au moins un monomère insaturé éthyléniquement, polymérisable par addition, un photoinitiateur ou un système photoinitiateur et un colorant,
caractérisé en ce que l'on utilise comme colorant un produit de réaction des complexes métallifères de phtalocyanines-polysulfonylchlorures et des alkylamines présentant au moins 11 atomes de carbone.

2. Matériau d'enregistrement photopolymérisable selon la revendication 1,
caractérisé en ce que l'on utilise des phtalocyanines de cuivre.

3. Matériau d'enregistrement photopolymérisable selon la revendication 1 ou 2,
caractérisé en ce que l'on utilise des alkylamines présentant 11 à 20 atomes de carbone.

4. Plaque d'impression photopolymérisable essentiellement constituée
a) d'une couche porteuse,
b) d'une couche photopolymérisable contenant au moins un liant élastomère, au moins un monomère insaturé éthyléniquement, polymérisable par addition et un photoinitiateur ou un système photoinitiateur et
c) une couche de protection,
caractérisée en ce que la couche photopolymérisable contient un colorant selon les revendications 1 à 3.

5. Plaque d'impression photopolymérisable selon la revendication 4,
caractérisée en ce que la couche photopolymérisable contient de 50 à 95 % en poids d'un copolymère-séquencé élastomère thermoplastique présentant une teneur en polystyrène de 10 à 40% en poids.

6. Plaque d'impression photopolymérisable selon la revendication 5,
caractérisée en ce que la couche photopolymérisable contient au moins un copolymère-séquencé (polystyrène-polybutadiène)₄Si radial présentant une teneur en polystyrène de 15-30% en poids.

7. Plaque d'impression photopolymérisable essentiellement constituée
a) d'une couche porteuse,
b) d'une couche photopolymérisable contenant au moins un liant élastomère, au moins un monomère insaturé éthyléniquement, polymérisable par addition et un photoinitiateur ou un système photoinitiateur,
c) une couche d'élastomère contenant au moins un copolymère-séquencé élastomère thermoplastique et
d) une couche de protection,
caractérisée en ce que la couche élastomère contient un colorant selon les revendications 1 à 3.

8. Plaque d'impression photopolymérisable selon la revendication 7,
caractérisée en ce que la couche élastomère contient de 50 à 95 % en poids d'un copolymère-séquencé élastomère thermoplastique présentant une teneur en polystyrène de 10 à 40% en poids.

9. Plaque d'impression photopolymérisable selon la revendication 8,
caractérisée en ce que la couche élastomère contient au moins un copolymère-séquencé (polystyrène-polybutadiène)₄Si radial présentant une teneur en polystyrène de 15-30% en poids.

10. Procédé de préparation de plaque d'impression photopolymérisable dans lequel on introduit, dans l'écartement existant entre les cylindres d'une calandre, une masse photopolymérisable d'au moins un liant élastomère, d'au moins un monomère insaturé éthyléniquement polymérisable par addition et d'un photoinitiateur ou d'un système photoinitiateur et on la stratifie entre un support et un élément de protection à plusieurs couches et on forme la couche photopolymérisable entre elles, l'élément de protection à plusieurs couches étant essentiellement constitué d'une couche élastomère content au moins un copolymère séquencé thermoplastique élastomère et un film de protection,
caractérisé en ce que la couche élastomère contient un colorant selon les revendications 1 à 3.
